# DEMANDE DE BREVET EUROPEEN

(11) **EP 3 457 431 A1**
(43) Date de publication de la demande: **20.03.2019**
(21) Numéro de dépôt: 18193937.2
(22) Date de dépôt: 12.09.2018
(51) Int. Cl.: H01L 21/02

(54) **PROCÉDÉ DE RÉALISATION D'UN ÉLÉMENT D'UN DISPOSITIF MICROÉLECTRONIQUE**

(30) Priorité: 13.09.2017 FR 1758492
(71) Demandeur: Commissariat à l'Energie Atomique et aux Energies Alternatives, 75015 Paris (FR)
(72) Inventeur: KHAZAKA, Rami, 38000 GRENOBLE (FR); BOGUMILOWICZ, Yann, 38000 GRENOBLE (FR); BOUTRY, Hervé, 38470 VINAY (FR)
(74) Mandataire: Decobert, Jean-Pascal

(57) **Abrégé**

La présente invention concerne un procédé de réalisation d'un élément d'un dispositif microélectronique sur un support comprenant une couche de base (2), une couche intercalée (3) et une couche de couverture (4), ledit procédé comprenant :
- une formation d'un volume de confinement incluant une gravure de la couche intercalée (3) sélectivement à la couche de base (2) et à la couche de couverture (4);
- un remplissage, par un matériau de remplissage constitutif de l'élément, du volume de confinement par une croissance épitaxiale à partir de la paroi latérale,

La formation du volume de confinement comprend une formation d'un trou au travers de toute l'épaisseur de la couche de couverture (4), et la gravure est une gravure anisotrope opérée par application d'un flux de gravure sur la couche intercalée (3) au travers du trou.

## Description

### DOMAINE DE L'INVENTION

La présente invention concerne la fabrication de parties de dispositifs par croissance épitaxiale latérale de matériaux, en particulier de matériaux semi-conducteurs.

L'invention trouve pour application avantageuse mais non limitative la fabrication de dispositifs microélectroniques. Par dispositif microélectronique, on entend tout type de dispositif réalisé avec les moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...). Un intérêt spécifique possible est l'intégration de matériaux semi-conducteurs ayant des propriétés opto-électriques supérieures à celles du silicium, tel du germanium ou des matériaux du type III-V, dans des dispositifs conventionnels, par exemple à base de silicium, pour des applications optoélectroniques ou de technologie CMOS.On peut aussi obtenir des intégrations hybrides de différents matériaux, en particulier au sein d'un même couche.

### ARRIERE-PLAN TECHNOLOGIQUE

Dans certaines situations, notamment pour fabriquer des parties de dispositifs comprenant du germanium, on a recours à des procédés dans lesquels le germanium fait l'objet d'une croissance épitaxiale sur la base d'une portion de matériaux semi-conducteurs, généralement du silicium.

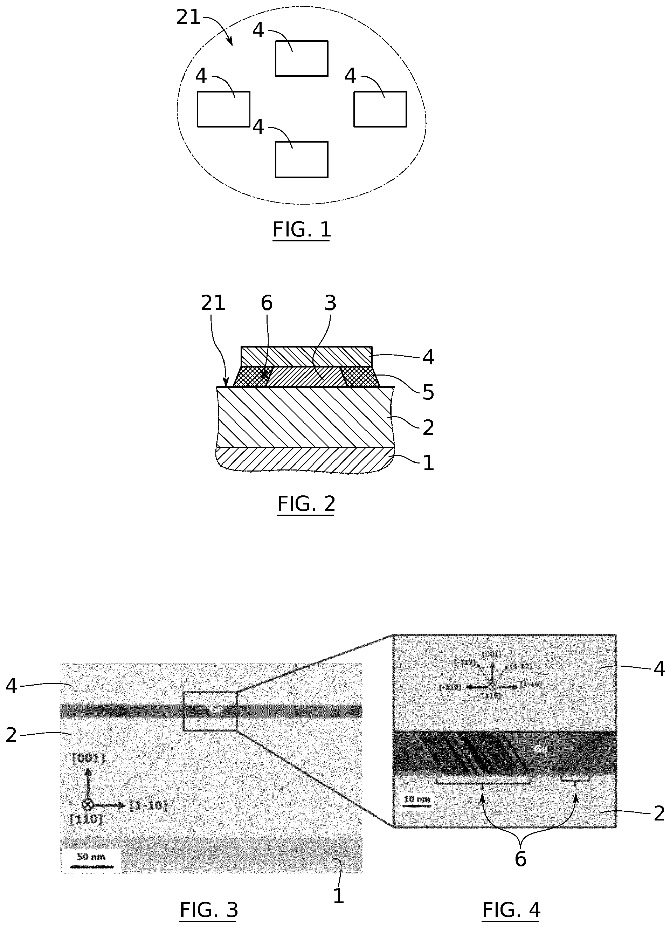

C'est dans ce contexte que le document Yamamoto *et al.* [Yamamoto et al. ECS Journal of Solid State Science and Technology 3, 353, 2014] divulgue une croissance de germanium sur la base d'un substrat de type Silicium sur isolant, encore appelé SOI (de l'anglais « Silicon On Insulator »). Selon ce document, illustré par les figures 1 et 2 de la présente demande, on procède d'abord à la réalisation de motifs en dioxyde de silicium sous forme de pavés 4 espacés les uns des autres au-dessus de l'empilement SOI ; ce type d'empilement comprend une couche de base 1, généralement du silicium, une couche isolante enterrée 2, généralement de dioxyde de silicium et une couche de silicium superficiel 3 servant à la construction ultérieure d'autres parties du dispositif. Un exemple de pavés 4 correspondant à la figure 1a de cette publication est donné en figure 1. On procède à une gravure du silicium superficiel permettant d'exposer la couche enterrée dans la zone 21 autour des pavés 4 et d'attaquer en partie la couche de silicium superficiel en dessous des pavés 4. Cette attaque latérale est visible à la figure 2. Elle permet de dégager un volume confiné entre la surface supérieure de la couche enterrée 2, la surface inférieure des pavés 4 et la paroi latérale de la couche superficielle 3 résiduelle. Ce volume fait ensuite l'objet d'un remplissage par du germanium 5 par croissance latérale sur la paroi de silicium de la cavité. Cette publication scientifique relate en outre que des défauts, schématisés au repère 6 en figure 2, peuvent être constatés dans le germanium issu de la croissance, en particulier à proximité de l'interface avec le silicium. Les figures 3 et 4 montrent des défauts que l'on peut ainsi rencontrer lors de la croissance du germanium, avec des défauts planaires et des problèmes d'orientation. Dans leur conclusion, Yamamoto *et al.* indiquent que les parties ayant des défauts peuvent être supprimées ultérieurement par une lithographie additionnelle suivie d'un processus de gravure. Il ressort que ce procédé engendre de nombreuses étapes sans pour autant garantir la qualité de la portion finalement fabriquée en germanium.

La publication brevet US A1 2012/025195 divulgue une croissance dans une zone confinée en forme de canal. Ce canal est formé par gravure d'un matériau sacrificiel amorphe ou polycristallin depuis une extrémité du canal à former, vers son autre extrémité, des parois latérales insensibles à la gravure guidant celle-ci lors de son exécution.

C'est un objet de l'invention que de pallier au moins en partie les inconvénients des techniques actuelles notamment en proposant un procédé amélioré.

### RESUME DE L'INVENTION

Un aspect non limitatif de l'invention est relatif à un procédé de réalisation d'un élément d'un dispositif microélectronique sur un support. Le support comprend successivement une couche de base, une couche intercalée et une couche de couverture.

Le procédé comprend d'abord une formation d'un volume de confinement, la formation incluant une gravure de la couche intercalée sélectivement à la couche de base et à la couche de couverture, et le volume étant délimité par une paroi latérale de la couche intercalée, une face supérieure de la couche de base et une face inférieure de la couche de couverture, la face inférieure étant située en regard de la face exposée.

Par ailleurs, on effectue un remplissage, par un matériau de remplissage constitutif de l'élément, d'au moins une partie du volume de confinement par une croissance épitaxiale du matériau à partir de la paroi latérale. Avantageusement, le matériau de la couche intercalée a une structure cristallographique du type cubique face centrée.

De manière avantageuse, la formation du volume de confinement comprend une formation d'un trou au travers de toute l'épaisseur de la couche de couverture de sorte à exposer une zone de la couche intercalée.

En outre, suivant un aspect avantageux de modes de réalisation non limitatifs, la gravure peut être une gravure sèche opérée un régime de gravure limité par la réaction de surface, par application d'un flux de gravure sur la couche intercalée au travers du trou. Suivant un autre aspect avantageux de modes de réalisation de l'invention, la gravure peut être une gravure humide. Alternativement ou cumulativement aux aspects avantageux précédents, la gravure est éventuellement configurée pour produire une vitesse de gravure au moins 25 % plus grande dans les directions cristallographiques [110] et [1-10] que dans les directions cristallographiques [010] et [100] du matériau de la couche intercalée, et de préférence au moins 35 % plus grande.

Ainsi, on produit une cavité formant le volume de confinement et obtenue par une gravure dont la vitesse selon les directions [110] et [1-10] est privilégiée, au détriment des directions [010] et [100] du fait de la sélection du régime de gravure limité par la réaction de surface. La section transversale de la paroi de la cavité est alors carrée aux tolérances de fabrication près. Et les directions des côtés du carré correspondent aux directions [010] et [100]. Or, le demandeur a remarqué que la croissance épitaxiale est bien moins sujette à des défauts lorsqu'elle est opérée par des flancs orientés suivant de telles directions. On constate donc beaucoup moins de défauts en comparaison avec une paroi de cavité qui serait obtenue par une gravure sèche avec un régime limité par le transport de masse, qui est plus isotrope et conduirait à une section octogonale, donc présentant des flancs supplémentaires d'orientation favorisant les défauts.

Par le biais du trou de la couche de couverture, la gravure est aussi aisément centrée dans une zone de la couche intercalée et se produit progressivement radialement à la direction en épaisseur de cette couche. La cavité est enfin très bien confinée dans cette configuration, produisant des éléments, par exemple en germanium, de bonne définition de forme.

Evidemment ce procédé peut être reproduit à divers endroits du support de sorte à fabriquer une pluralité d'éléments simultanément.

Un autre aspect séparable de la présente invention concerne un dispositif qui peut être obtenu par le procédé. Il présente avantageusement une section carrée.

### BREVE INTRODUCTION DES FIGURES

D'autres caractéristiques, buts et avantages de la présente invention apparaitront à la lecture de la description détaillée qui suit, en regard des dessins annexés, donnés à titre d'exemples, non limitatifs, et sur lesquels :
- La FIGURE 1 illustre en vue de dessus un enseignement du document Yamamoto *et al.* [Yamamoto et al. ECS Journal of Solid State Science and Technology 3, 353, 2014] ;
- la FIGURE 2 en montre une vue en coupe partielle ;
- les FIGURES 3 et 4 présentent des possibilités de défauts lors d'une croissance de germanium ;
- les FIGURES 5 à 7 schématisent trois étapes d'un mode de réalisation non limitatif de l'invention ;
- la FIGURE 8 montre en vue de dessus un résultat possible obtenu grâce à l'invention.

Les dessins sont donnés à titre d'exemples et ne sont pas limitatifs de l'invention. Ils constituent des représentations schématiques de principe destinées à faciliter la compréhension de l'invention et ne sont pas nécessairement à l'échelle des applications pratiques. En particulier les épaisseurs relatives des couches ne sont pas représentatives de la réalité.

### DESCRIPTION DETAILLEE

Avant d'entamer une revue détaillée de modes de réalisation de l'invention, sont énoncées ci-après des caractéristiques optionnelles qui peuvent éventuellement être utilisées suivant toute association ou alternativement :
- la gravure est configurée pour produire une vitesse de gravure au moins 25% plus grande dans des directions cristallographiques [110] et [1-10] que dans des directions cristallographiques [010] et [100] du matériau de la couche intercalée 3, et de préférence au moins 35% plus grande ;
- on choisit une couche intercalée 3 dont le matériau a une structure cristallographique du type cubique dont deux faces opposées sont dirigées perpendiculairement à la dimension en épaisseur de la couche intercalée 3 ;
- la couche intercalée 3 est choisie avec une dimension en épaisseur inférieure à 300 nm ;
- la formation du trou est configurée pour obtenir un diamètre de trou compris entre 50 et 200 nm, de préférence égal à 150 nm ;
- la gravure est une gravure sèche produite par un flux de gravure dans une machine de dépôt chimique en phase vapeur ;
- le remplissage est produit par dépôt chimique en phase vapeur dans la machine de dépôt chimique en phase vapeur ;
- on utilise une couche intercalée en matériau à structure cristallographique de type diamant ou zinc-blende ;
- la couche intercalée 3 est en matériau semi-conducteur ;
- on utilise du silicium comme matériau semi-conducteur ;
- la gravure est une gravure sèche opérée à une température inférieure à 850°C, de préférence inférieure à 820°C et de préférence égale à 800°C ;
- la température est supérieure à 700°C, et de préférence supérieure à 750°C ;
- on utilise un matériau semi-conducteur comme matériau de remplissage 5 ;
- on utilise du germanium comme matériau de remplissage 5 ;
- la couche de base 2 est une couche électriquement isolante enterrée et la couche intercalée 3 est une couche d'un matériau semi-conducteur, formant un empilement semi-conducteur sur isolant.

Il est précisé que, dans le cadre de la présente invention, le terme « sur » ou « au-dessus » ne signifie pas obligatoirement « au contact de ». Ainsi, par exemple, le dépôt d'une couche sur une autre couche, ne signifie pas obligatoirement que les deux couches sont directement au contact l'une de l'autre mais cela signifie que l'une des couches recouvre au moins partiellement l'autre en étant, soit directement à son contact, soit en étant séparée d'elle par un film, ou encore une autre couche ou un autre élément. Une couche peut par ailleurs être composée de plusieurs sous-couches d'un même matériau ou de matériaux différents.

Il est précisé que dans le cadre de la présente invention, l'épaisseur d'une couche ou du substrat se mesure selon une direction perpendiculaire à la surface selon laquelle cette couche ou ce substrat présente son extension maximale.

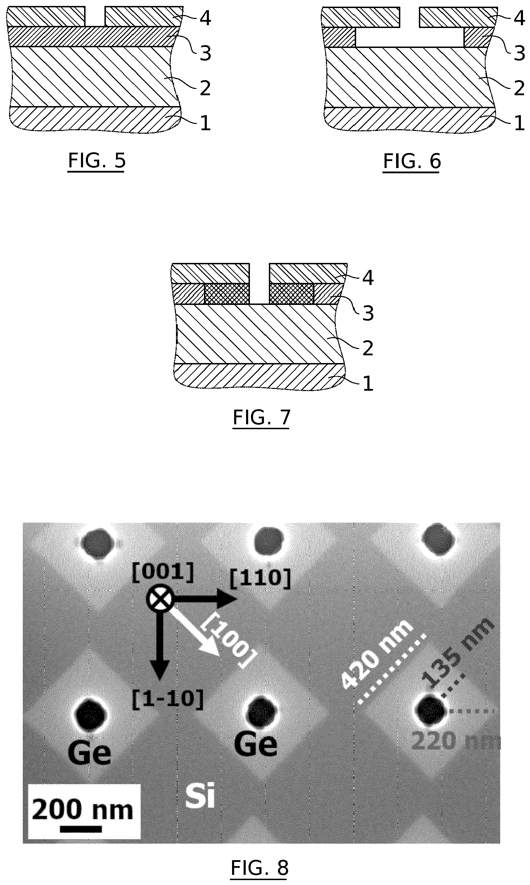

De manière connue en soi, le procédé de l'invention peut être mis en oeuvre sur la base d'un support comprenant ou constitué d'un empilement du type semi-conducteur sur isolant. Dans ce contexte, la figure 5 présente par exemple un empilement dont la couche inférieure est formée par un substrat semi-conducteur, par exemple en silicium et portant la référence 1. Au-dessus de cette couche 1, une couche électriquement isolante 2 est située, elle est encore appelée couche de base dans la suite de la description. Il peut s'agir d'une couche d'oxyde enterré généralement connu sous l'acronyme BOX (de l'anglais « Buried Oxyde »). Dans le cas le plus commun, cette couche 2 est en dioxyde de silicium, mais l'invention n'exclut pas d'autres matériaux isolants, notamment à partir d'autres oxydes ou de nitrures. Au-dessus de la couche 2, une couche 3 peut être typiquement en un matériau semi-conducteur, notamment du silicium. Très avantageusement, la couche 3 a une structure cristallographique de type cubique face centrée

Notamment deux faces opposées de l'enveloppe cubique du cristal sont de manière avantageuse dirigées perpendiculairement à l'épaisseur de la couche de matériau 3; la direction cristallographique [001] est ainsi dirigée selon la dimension en épaisseur de la couche 3.

On peut par exemple employer des matériaux ayant une structure en cristal de type diamant ou zinc-blende. Un cristal de type diamant ou zinc-blende comporte d'une manière générale un atome :
- aux 8 sommets d'un cube ;
- au centre de chacune des faces de ce cube ;
- dans quatre des huit sites tétraédriques du cube, c'est-à-dire au centre du tétraèdre formé par un coin du cube et les trois atomes au centre des trois faces adjacentes à ce coin.

Cette couche de matériau peut être la couche superficielle d'un empilement SOI, la couche de base 2 formant la couche isolante de cet empilement. À titre d'exemple, l'épaisseur de la couche 3 est inférieure ou égale à 300 nm, de préférence inférieure à 150 nm et notamment comprise entre 10 et 100 nanomètres.

Une nature monocristalline de la couche 3 est bénéfique pour produire une gravure anisotropique, au contraire de matériaux amorphes ou polycristallins.

Comme le montre la figure 5, la couche 3 est surmontée d'une couche, dite couche de couverture 4. Dans la mesure où, la couche 3 se trouve entre les couches 2 et 4, elle est appelée dans le cas de l'invention « couche intercalée ».

La couche de couverture peut être une couche d'oxyde du matériau semi-conducteur de la couche intercalée 3. Par exemple, une couche de dioxyde de silicium, notamment d'une épaisseur comprise entre 50 et 100 nanomètres, et de préférence 70 nm, peut être déposée au-dessus d'une couche intercalée 3 faite de silicium. On peut par exemple utiliser un procédé d'oxydation thermique à partir du matériau semi-conducteur de la couche 3 pour la création de la couche 4. Cette oxydation thermique peut être obtenue à une température entre 800 et 1000°C et avec un apport de vapeur d'eau ou de dioxygène. Notamment si l'on souhaite partir d'une couche intercalée d'épaisseur réduite, on peut aussi par exemple former un couche d'oxyde, notamment de silicium, déposée de préférence par CVD, par exemple de type TEOS (de formule Si(OEt)₄) ou HTO pour High temperature oxide, ou oxyde à haute température).

De préférence, à ce stade du procédé, l'ensemble des couches en présence est déposée pleine plaque. De préférence, les couches sont parallèles entre-elles et ont des surfaces planes. Avantageusement, la couche intercalée (3) est configurée pour recouvrir complètement la couche de base (2).

La figure 5 montre la création d'au moins un trou au travers de l'intégralité de l'épaisseur de la couche de couverture 4, de sorte à atteindre la couche intercalée 3. L'emploi de trous permet d'atteindre la couche intercalée 3 uniquement par sa face supérieure, celle qui est surmontée par la couche de couverture. Cette zone exposée de la couche intercalée est dirigée tranversalement (typiquement perpendiculairement) à la direction en épaisseur des couches. La gravure s'opère en attaquant le matériau de la couche 3 depuis la portion de la face supérieure de cette dernière accessible par le trou et progressivement autour de cet accès, dans toutes les directions, mais avec un différentiel de vitesse de gravure selon les directions. La gravure ainsi mise en oeuvre est donc, au moins dans une première phase, centrée par rapport au trou. Avantageusement, autant de trous sont formés que de cavités sont à créer pour la réalisation d'une pluralité d'éléments obtenus par croissance latérale. À titre d'exemple, la création des trous peut être opérée par gravure. Le ou les trous comportent une section fermée et cette dernière peut être de forme variable. On peut notamment former des trous de section circulaire, notamment ayant un diamètre avantageusement de 150nm ou ayant une autre forme de section dont la plus grande dimension dans le plan est supérieure à 100nm et/ou inférieure à 200nm et possiblement égale à 150nm. La gravure peut être une gravure sèche. On pourra avoir recours à des procédés classiques pour réaliser cette gravure localisée, notamment avec des procédés de lithographie. Avantageusement, pour contrôler la gravure du trou en épargnant au moins en partie l'épaisseur de la couche intercalée 3, la cinétique de la gravure est contrôlée et/ou le fluide de gravure dans le cas d'une gravure humide est choisi pour être sélectif de sorte à attaquer le matériau de la couche de couverture 4 sans attaquer, ou en attaquant peu, la couche intercalée 3. Un acide du type acide fluorhydrique (HF) peut convenir à cet effet. On utilisera cependant plutôt une gravure plasma sèche anisotrope, qui évite de trop élargir le trou de gravure contrairement à une gravure humide plus isotrope.

Le trou ainsi formé permet d'accéder à la couche 3 pour y appliquer une gravure. Cette dernière est configurée pour être sélective relativement aux couches de couverture et de base de sorte à n'attaquer que la couche intercalée 3 et non pas les matériaux des couches qui l'entourent. Dans le cas de couches 2 et 4 en dioxyde de silicium, on pourra utiliser une gravure du silicium formant la couche intercalée qui n'attaque pas le dioxyde de silicium. A titre d'exemple, une gravure avec un flux de HCl pourra convenir pour une telle sélectivité.

Après un certain temps de gravure, on obtient une cavité constitutive d'un volume de confinement, visible en creux à la figure 6. À titre d'exemple, la dimension en largeur, perpendiculairement à la dimension en épaisseur des couches, peut être supérieure à 200 nm et/ou inférieure à 2 microns, et par exemple comprise entre 400 nm et 1200 nm. La durée de gravure permet d'ajuster la dimension latérale de la cavité. Il convient de préserver une portion de la couche intercalée 3. En effet, la cavité est définie latéralement par cette dernière, et en partie inférieure par la couche de base, et en partie supérieure par la couche de couverture. On notera la précision de délimitation de la cavité et le placement précis de l'accès, par le trou, pour la gravure du matériau de la couche intercalée. De préférence, la gravure est configurée pour que le contour de la cavité soit de section fermée, avantageusement entièrement dans la couche 3. On formera éventuellement la cavité de sorte à conserver au moins deux parois latérales dans le matériau sacrificiel, les autres parois pouvant être du même matériau ou dans un autre.

Selon l'invention, la gravure de la couche intercalée 3 est réalisée de manière spécifique de sorte à contrôler la forme et l'orientation de la cavité. En effet, le demandeur a constaté qu'il était nettement souhaitable de produire une cavité de section carrée orientée de manière précise d'un point de vue de la cristallographie du matériau qui constitue cette couche.

A cet effet, la gravure n'est avantageusement pas produite de manière conventionnelle avec une gravure sèche à une température relativement élevée pour atteindre un régime de gravure à limitation par transport de masse. Ces conditions conduisent à une gravure isotrope et différentes facettes seront révélées ce qui induit la formation des défauts notamment sur les facettes du type [110]. Au contraire, combattant ainsi un préjugé, l'invention emploie avantageusement, suivant un mode de réalisation, un régime de limitation par réaction de surface pour mettre en oeuvre une gravure sèche, de type plasma.

Pour y parvenir, le dispositif est avantageusement introduit dans un réacteur de dépôt chimique en phase vapeur (ce type de dépôt est aussi connu de l'acronyme anglais CVD pour « Chemical Vapor Déposition »). La gravure, par exemple avec un flux de vapeur d'acide chlorhydrique HCl pour le cas d'un matériau à graver du type silicium, est réalisée. La température de cette gravure est sélectionnée de sorte à rester dans le contexte d'un régime de gravure à limitation de réaction de surface. En particulier, dans le cas du silicium, la température de gravure sera strictement inférieure à 850°C, de préférence inférieure à 820°C. Dans cet exemple la pression du flux peut être entre 10 Torr et pression atmosphérique, et de préférence égale à 80 Torr. Un flux de H₂ est aussi avantageusement généré, par exemple entre quelques 1 slm et 40 slm de préférence 20 slm (slm est l'acronyme de « standard liter per minute » en anglais, pour litres normaux par minute). Le flux de HCl peut être entre 1 slm et 20 slm, et de préférence 15 slm.

La température sélectionnée dépendra du fluide utilisé pour la gravure. Ainsi, si au lieu du HCl on emploie une gravure par du Cl₂ en présence de nitrogène, la température peut être significativement réduite par exemple en dessous de 750°C. Si la couche intercalée 3 est en germanium, on pourra typiquement utiliser une température de gravure strictement inférieure à 500°C, avantageusement inférieure à 475°C, et de préférence inférieure à 450°C, pour préserver le régime limité par réaction de surface. Suivant un autre exemple, la couche intercalée 3 est en silicium germanium, avec une proportion du type Si_{0.67}Ge_{0.33} auquel cas ce régime de gravure peut être maintenu jusqu'à une température au plus de 775°C et de préférence inférieure ou égale à 750°C. Pour un silicium germanium du type Si_{0.50}Ge_{0.50} la température maximale sera de 750°C et de préférence inférieure ou égale à 730°C. On comprend que la température maximale à sélectionner dépend des variations des concentrations de germanium et de silicium dans ce cas.

On pourra faire varier la vitesse de gravure en jouant sur la pression du flux de vapeur du fluide de gravure.

Suivant une autre possibilité, la gravure est une gravure humide. Par exemple, on peut appliquer un liquide de gravure au travers du trou. Dans le cas du silicium à titre d'exemple de matériau à graver, une solution de préférence aqueuse et comprenant de l'hydroxyde de potassium. La gravure humide, appliquée à un espace confiné, permet d'obtenir un différentiel de vitesse de gravure selon les directions cristallographiques.

D'une manière générale, la gravure de l'invention est configurée pour produire des vitesses de gravure différente suivant les directions cristallographiques du matériau de la couche 3. Suivant un cas préféré, la gravure, sèche ou humide, est configurée pour obtenir une vitesse de gravure supérieure dans les directions cristallographiques [110] et [1-10], au détriment des vitesses de gravure des directions [010] et [100]. De préférence, ces différences de vitesse sont importantes, et au moins de 25 % entre les directions privilégiées et les directions non privilégiées. Cette différenciation peut monter à plus de 35 %. On comprend que la vitesse la plus élevée est au moins 25% (voire au moins 35%, et possiblement au moins 60%) plus grande que la vitesse la plus basse. En particulier, on va privilégier une vitesse de gravure supérieure dans les directions cristallographiques [110] et [1-10], au détriment des vitesses de gravure des directions [010] et [100]. Par exemple, la vitesse de gravure dans la direction [110] peut-être supérieure ou égale à 27 nm/minute et/ou la vitesse de gravure dans la direction [010] peut-être de l'ordre de 16 nm/minute. Suivant un autre mode de réalisation, la différence de vitesses de gravure est d'au moins 5 nm/minute, et possiblement d'au moins 7, voire 10 nm/minute.

D'une manière générale, la gravure de l'invention est anisotrope en particulier dans des directions de plans perpendiculaires à l'épaisseur de la couche et configurée de sorte à produire une cavité de section carrée. Elle est à opposer à une gravure isotrope, élargissant la cavité sans produire un carré.

Les directions des vitesses les plus grandes vont définir les diagonales d'un carré, aux tolérances de réalisation près. De ce fait, les côtés du carré sont orientés suivants la direction cristallographique [100] ou perpendiculairement à cette direction. Ce point est d'importance pour la phase de croissance du matériau de remplissage, tel du germanium.

Ce remplissage est avantageusement opéré par une épitaxie produite dans le même réacteur que celui ayant servi à la gravure du matériau de la couche intercalée 3. À titre d'exemple, du germanium peut être déposé sélectivement dans la cavité en utilisant une source gazeuse de H₂-GeH₄ à une température de entre 350°C et 650°C, de préférence 400°C.

Le résultat obtenu est schématisé à la figure 7, avec la présence du matériau de remplissage 5 dans une partie de la cavité produite précédemment. Le volume finalement occupé par le matériau de remplissage 5 dépendra de la durée et des paramètres de cette phase de croissance. La figure 8 montre en vue de dessus, la couche de couverture 4 qui a été dans ce cas précédemment enlevée, un exemple de résultat obtenu pour une pluralité de cavités remplies de germanium. On notera la section carrée très bien définie et l'orientation idéalement dirigée des facettes de l'élément germanium. Les défauts de germanium en sont considérablement réduits. En effet, la croissance se produit uniquement dans les directions perpendiculaires aux facettes de la section carrée des cavités, ces directions étant les moins propices à des défauts. En particulier, si la gravure de la couche intercalée avait été opérée d'une autre manière que selon l'invention, on aurait obtenu une section de cavité du type octogonal avec des directions de gravure malheureusement favorables à des défauts.

On a précédemment donné l'exemple avantageux du germanium pour le remplissage, mais on pourra mettre en oeuvre l'invention avec d'autres matériaux semi-conducteurs, des matériaux du type III-V et des matériaux du groupe IV, tels que GaAS, InAs, GaSb, SiC, ou tous matériaux aptes à croitre par épitaxie sur le matériau de la couche intercalée 3.

Sauf indication spécifique du contraire, des caractéristiques techniques décrites en détail pour un mode de réalisation donné peuvent être combinées à des caractéristiques techniques décrites dans le contexte d'autres modes de réalisation décrits à titre exemplaire et non limitatif, dont ceux expliqués en détail ci-dessus.

### REFERENCES

1. Substrat
2. Couche de base
3. Couche intercalée
4. Couche de couverture
5. Matériau de remplissage
6. Défauts

## Revendications

1. Procédé de réalisation d'un élément d'un dispositif microélectronique sur un support comprenant successivement une couche de base (2), une couche intercalée (3) et une couche de couverture (4), ledit procédé comprenant :
- une formation d'un volume de confinement incluant une gravure de la couche intercalée (3) sélectivement à la couche de base (2) et à la couche de couverture (4), le volume de confinement étant délimitée par une paroi latérale de la couche intercalée (3), une face supérieure de la couche de base (2) et une face inférieure de la couche de couverture (4), la face inférieure étant située en regard d'une face exposée de la couche de couverture (4);
- un remplissage, par un matériau de remplissage constitutif de l'élément, d'au moins une partie du volume de confinement par une croissance épitaxiale du matériau à partir de la paroi latérale, le matériau de remplissage ayant une structure cristallographique du type cubique,
**caractérisé en ce que** la formation du volume de confinement comprend une formation d'un trou au travers de toute l'épaisseur de la couche de couverture (4) de sorte à exposer une zone de la couche intercalée (3), et **en ce que** la gravure est opérée par application d'une gravure sur la couche intercalée (3) au travers du trou dans une zone de la couche intercalée (4) centrée autour du trou, soit par une gravure sèche à un régime de gravure limité par la réaction de surface, soit par une gravure humide.

2. Procédé selon la revendication précédente, dans lequel la gravure est configurée pour produire une vitesse de gravure au moins 25% plus grande dans des directions cristallographiques [110] et [1-10] que dans des directions cristallographiques [010] et [100] du matériau de la couche intercalée (3), et de préférence au moins 35% plus grande.

3. Procédé selon l'une des revendications précédentes, dans lequel on choisit une couche intercalée (3) dont le matériau a une structure cristallographique du type cubique dont deux faces opposées sont dirigées perpendiculairement à la dimension en épaisseur de la couche intercalée (3).

4. Procédé selon l'une des revendications précédentes dans lequel la couche intercalée (3) est choisie avec une dimension en épaisseur inférieure à 300 nm.

5. Procédé selon l'une des revendications précédentes, dans lequel la formation du trou est configurée pour obtenir un diamètre de trou compris entre 50 et 200 nm, de préférence égal à 150 nm.

6. Procédé selon l'une des revendications précédentes dans lequel la gravure est une gravure sèche produite par un flux de gravure dans une machine de dépôt chimique en phase vapeur.

7. Procédé selon la revendication précédente, dans lequel le remplissage est produit par dépôt chimique en phase vapeur dans la machine de dépôt chimique en phase vapeur.

8. Procédé selon l'une des revendications précédentes, dans lequel on utilise une couche intercalée en matériau à structure cristallographique de type diamant ou zinc-blende.

9. Procédé selon l'une des revendications précédentes, dans lequel la couche intercalée (3) est en matériau semi-conducteur.

10. Procédé selon la revendication précédente dans lequel on utilise du silicium comme matériau semi-conducteur.

11. Procédé selon la revendication précédente, dans lequel la gravure est une gravure sèche opérée à une température inférieure à 850°C, de préférence inférieure à 820°C et de préférence égale à 800°C, la température étant de préférence supérieure à 700°C, et de préférence supérieure à 750°C.

12. Procédé selon l'une des revendications précédentes, dans lequel la couche intercalée (3) est configurée pour recouvrir complètement la couche de base (2).

13. Procédé selon l'une des revendications précédentes, dans lequel on utilise un matériau semi-conducteur comme matériau de remplissage (5).

14. Procédé selon la revendication précédente, dans lequel on utilise du germanium comme matériau de remplissage (5).

15. Procédé selon la revendication précédente dans lequel la couche de base (2) est une couche électriquement isolante enterrée et la couche intercalée (3) est une couche d'un matériau semi-conducteur, formant un empilement semi-conducteur sur isolant.
